# EUROPEAN PATENT SPECIFICATION

(11) **EP 2 339 638 B1**
(45) Date of publication and mention of the grant of the patent: **19.09.2012**
(21) Application number: 10172000.1
(22) Date of filing: 05.08.2010
(51) Int. Cl.: H01L 29/786, H01L 29/08

(54) **Transistor**
Transistor
Transistor

(30) Priority: 24.12.2009 KR 20090131292
(43) Date of publication of application: 29.06.2011
(73) Proprietor: Samsung Electronics Co., Ltd., Suwon-si Gyeonggi-do 442-742 (KR)
(72) Inventor: Sang-hun, Jeon, 449-712, Gyeonggi-do (KR); I-hun, Song, 449-712, Gyeonggi-do (KR); Chang-jung, Kim, 449-712, Gyeonggi-do (KR); Sung-ho, Park, 449-712, Gyeonggi-do (KR)
(74) Representative: Greene, Simon Kenneth

(56) References cited:
- US-A1- 2005 104 065
- US-A1- 2009 224 238

## Description

Example embodiments relate to a transistor, and more particularly, to an oxide transistor.

### BACKGROUND

Transistors are commonly used as switching devices or driving devices in electronic devices. In particular, a thin film transistor (TFT) may be formed on a glass substrate or on a plastic substrate. As a result, TFTs may be often used in the field of flat panel display devices, e.g., liquid crystal display devices and/or organic light emitting display devices.

In order to improve the operational characteristics of a transistor, attempts have been made to utilize an oxide semiconductor layer as a channel layer of the transistor. This method is mainly employed for manufacturing TFTs for flat panel display devices. However, the threshold voltage may be difficult to control in a transistor having an oxide semiconductor layer as the channel layer (hereinafter, an oxide transistor).

In more detail, when a silicon layer is used as a channel layer, a threshold voltage may be more easily controlled by controlling a doping concentration. However, in the oxide transistor, controlling a threshold voltage through doping due to a self-compensation phenomenon may be difficult. Also, the oxide transistor may be a majority carrier device in which the types of a channel and a carrier charge that moves from a source to a drain are the same. Such a majority carrier device may be operated in an accumulation mode and generally has a threshold voltage less than 0 V (based on an n-type oxide transistor). Accordingly, when an oxide semiconductor layer is used as a channel layer, realizing an enhancement mode transistor having a threshold voltage greater than 0 V (based on an n-type oxide transistor) may be difficult.

US 2009/0224238 describes a transistor with an insertion layer between a channel layer of gate oxide and a gate insulating layer.

US 2005/0104065 provides a silicon semiconductor device with oxygen implantation regions of high band gap provided between the channel and the source and between the channel and the drain.

### SUMMARY

Provided are oxide transistors of which threshold voltages may be more easily controlled. Additional aspects will be set forth in part in the description which follows and, in part, will be apparent from the description, or may be learned by practice of example embodiments.

In an aspect of the invention, there is provided a transistor accoring to claim 1.

A potential barrier increases between the channel layer and the source electrode due to the semiconductor insertion layer. When the channel layer is an n-type channel layer, a work function of the semiconductor insertion layer may be greater than that of the channel layer. In example embodiments, an n-type carrier concentration of the semiconductor insertion layer may be lower than that of the channel layer.

When the channel layer is a p-type channel layer, a work function of the semiconductor insertion layer may be smaller than that of the channel layer. In example embodiments, a p-type carrier concentration of the semiconductor insertion layer may be lower than that of the channel layer.

The channel layer may include any one selected from the group consisting of ZnO, GaO, InO, SnO, CdO, CaO, AIO, TiO, TaO, NbO, LnO, HfO, ZrO, YO, NiO, CuO, and a combination thereof, or oxide semiconductors thereof. The channel layer may be formed of a ZnO-based oxide semiconductor. The ZnO-based oxide semiconductor may further include at least one selected from the group consisting of In, Ga, Sn, Ti, Zr, Hf, Y, and Ta.

The semiconductor insertion layer may include one selected from the group consisting of SiC, AIN, GaN, InN, AIP, GaP, InAs, GaAs, AlAs, InSb, GaSb, ZnS, CdS, ZnTe, CdTe, CdSe, CdS, ZnO, GaO, InO, SnO, CdO, CaO, AIO, TiO, TaO, NbO, LnO, HfO, ZrO, YO, NiO, CuO, and a combination thereof, or compounds thereof.

The semiconductor insertion layer may have an energy bandgap of about 0.5 to about 4.0 eV. The semiconductor insertion layer may have a thickness of about 1 to about 300 Å. The transistor may be an enhancement mode transistor.

The semiconductor insertion layer may be a first semiconductor insertion layer, and a second semiconductor insertion layer may be between the channel layer and the drain electrode. The first and second semiconductor insertion layers may be formed of the same material. The transistor may be a thin film transistor (TFT) having a top-gate structure. The transistor may be a TFT having a bottom-gate structure.

In example embodiments, the transistor may further include a gate insulating layer between the channel layer and the gate electrode. The gate insulating layer may include one selected from the group consisting of a silicon oxide layer, a silicon nitride layer, and a high-dielectric material layer having a dielectric constant greater than that of the silicon nitride layer.

The gate insulating layer may have a structure including at least two stacked layers from among the silicon oxide layer, the silicon nitride layer, and the high-dielectric material layer. The transistor may further include an insulating layer on the gate insulating layer and the gate electrode.

In another aspect, there is provided a transistor comprising
a channel layer including an oxide semiconductor;
a gate electrode corresponding to the channel layer;
a source electrode and a drain electrode, the source electrode and drain electrode being of the same material; and
a semiconductor insertion layer between the channel layer and the source electrode, but not between the channel layer and the drain electrode, the semiconductor insertion layer being a layer comprising semiconductor arranged to provide a potential barrier between the channel layer and the source electrode greater than the potential barrier between the channel layer and the drain electrode.

### BRIEF DESCRIPTION OF THE DRAWINGS

These and/or other aspects will become apparent and more readily appreciated from the following description of the embodiments, taken in conjunction with the accompanying drawings of which:
FIGS. 1 through 4 are cross-sectional views illustrating a transistor having an asymmetrical source/drain structure, according to example embodiments;
FIGS. 5 through 8 are cross-sectional views illustrating a transistor having a symmetrical source/drain structure, according to example embodiments;
FIG. 9 is an energy band diagram illustrating a source electrode, an insertion layer, and a channel layer of a transistor, according to example embodiments;
FIG. 10 is an energy band diagram illustrating a source electrode and a channel layer of a transistor, according to a comparative example;
FIG. 11 is an energy band diagram illustrating a source electrode, an insertion layer, and a channel layer of a transistor, according to example embodiments;
FIG. 12 is an energy band diagram illustrating a source electrode and a channel layer of a transistor, according to another comparative example; and
FIG. 13 is a graph illustrating gate voltage V_{g}-drain current I_{d} characteristics of transistors, according to example embodiments and a comparative example.

### DETAILED DESCRIPTION

Various example embodiments will now be described more fully with reference to the accompanying drawings in which example embodiments are shown. Example embodiments may, however, be embodied in many different forms and should not be construed as being limited to example embodiments set forth herein; rather, these example embodiments are provided so that this disclosure will be thorough and complete, and will fully convey the concept of example embodiments to those of ordinary skill in the art.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. As used herein the term "and/or" includes any and all combinations of one or more of the associated listed items.

It will be understood that, although the terms "first", "second", etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed below could be termed a second element, component, region, layer or section without departing from the teachings of example embodiments.

Spatially relative terms, such as "beneath," "below," "lower," "above," "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the example term "below" can encompass both an orientation of above and below. The device may be otherwise oriented (rotated 90 degrees or at other orientations) and the spatially relative descriptors used herein interpreted accordingly.

The terminology used herein is for the purpose of describing particular embodiments only and is not intended to be limiting of example embodiments. As used herein, the singular forms "a," "an" and "the" are intended to include the plural forms as well, unless the context clearly indicates otherwise. It will be further understood that the terms "comprises", "comprising", "includes" and/or "including," if used herein, specify the presence of stated features, integers, steps, operations, elements, and/or components, but do not preclude the presence or addition of one or more other features, integers, steps, operations, elements, components, and/or groups thereof.

Example embodiments are described herein with reference to cross-sectional illustrations that are schematic illustrations of idealized embodiments (and intermediate structures) of example embodiments. As such, variations from the shapes of the illustrations as a result, for example, of manufacturing techniques and/or tolerances, are to be expected. Thus, example embodiments should not be construed as limited to the particular shapes of regions illustrated herein but are to include deviations in shapes that result, for example, from manufacturing. For example, an implanted region illustrated as a rectangle will, typically, have rounded or curved features and/or a gradient of implant concentration at its edges rather than a binary change from an implanted to a non-implanted region. Likewise, a buried region formed by implantation may result in some implantation in the region between the buried region and the surface through which the implantation takes place. Thus, the regions illustrated in the figures are schematic in nature and their shapes are not intended to illustrate the actual shape of a region of a device and are not intended to limit the scope of example embodiments.

Unless otherwise defined, all terms (including technical and scientific terms) used herein have the same meaning as commonly understood by one of ordinary skill in the art to which example embodiments belong. It will be further understood that terms, such as those defined in commonly-used dictionaries, should be interpreted as having a meaning that is consistent with their meaning in the context of the relevant art and will not be interpreted in an idealized or overly formal sense unless expressly so defined herein.

In the drawings, the thicknesses of layers and regions are exaggerated for clarity. Like reference numerals in the drawings denote like elements.

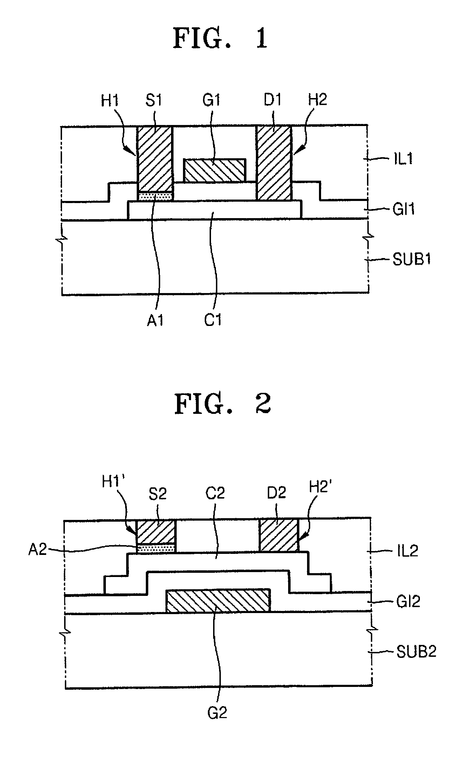

FIG. 1 is a cross-sectional view illustrating a transistor according to example embodiments. The transistor of example embodiments may be a thin film transistor (TFT) having a top-gate structure in which a gate electrode G1 is formed above a channel layer C1.

Referring to FIG. 1, the channel layer C1 may be formed on a substrate SUB1. The substrate SUB1 may be a silicon substrate, a glass substrate, a plastic substrate or other substrates used in a general semiconductor device process. The substrate SUB1 may or may not be transparent. The channel layer C1 is an oxide semiconductor layer. The channel layer C1 may be an n-type oxide semiconductor layer or a p-type oxide semiconductor layer. When the channel layer C1 is an n-type oxide semiconductor layer, the channel layer C1 may include one selected from the group consisting of ZnO, GaO, InO, SnO, CdO, CaO, AlO, TiO, TaO, NbO, LnO, HfO, ZrO, YO, and a combination thereof, or oxides thereof, for example.

When the channel layer C1 is formed of a ZnO-based oxide semiconductor from among these materials, the channel layer C1 may further include at least one material selected from the group consisting of In, Ga, Sn, Ti, Zr, Hf, Y, and Ta. When the channel layer C1 is a p-type oxide semiconductor layer, the channel layer C1 may include one selected from the group consisting of NiO, CuO, and a combination thereof, or oxides thereof, for example. The channel layer C1 may have a single layer structure or a multi-layer structure. Although not shown in FIG. 1, an insulating layer (not shown) may be interposed between the substrate SUB1 and the channel layer C1. That is, the insulating layer may be formed on the substrate SUB1, and the channel layer C1 may be formed on the insulating layer.

A gate insulating layer GI1 may be formed on the substrate SUB1 so as to cover the channel layer C1. The gate insulating layer GI1 may be a silicon oxide layer, a silicon nitride layer, or another material layer, for example, a high-dielectric material layer having a dielectric constant greater than that of the silicon nitride layer. The gate insulating layer GI1 may have a structure in which at least two layers from among the silicon oxide layer, the silicon nitride layer, and the high-dielectric material layer are stacked.

A gate electrode G1 may be formed on the gate insulating layer GI1. The gate electrode G1 may be formed to correspond to a center portion of the channel layer C1. The gate electrode G1 may be formed of a general electrode material, e.g., a metal or a metal oxide.

A source electrode S1 is and a drain electrode D1 may be formed on the channel layer C1 so as to respectively contact opposing sides of the channel layer C1. The source electrode S1 and the drain electrode D1 may be formed of a metal. The source electrode S1 and the drain electrode D1 may be a metal layer that is the same as the gate electrode G1, but may be another metal layer.

A semiconductor insertion layer A1 (hereinafter, an insertion layer A1) is selectively formed between the source electrode S1 and the channel layer C1. In other words, the source electrode S1 and the channel layer C1 contact each other through the insertion layer A1. In example embodiments, the drain electrode D1 and the channel layer C1 may directly contact each other.

The insertion layer A1 increases or generates a potential barrier between the channel layer C1 and the source electrode S1. That is, the potential barrier between the channel layer C1 and the source electrode S1 is increased by the insertion layer A1. A height and a thickness of the potential barrier may vary according to a material or a thickness of the insertion layer A1, and consequently, a threshold voltage of the transistor may be controlled. Accordingly, the insertion layer A1 may be referred to as a threshold voltage controlling layer.

For example, the insertion layer A1 may be a non-oxide semiconductor layer including at least one selected from the group consisting of a Group IV-IV compound, a Group III-V compound, a Group II-VI compound, and a Group I-VII compound, an oxide semiconductor layer, or a combination of the non-oxide semiconductor layer and the oxide semiconductor layer. In more detail, the insertion layer A1 may include one selected from the group consisting of SiC, AIN, GaN, InN, AlP, GaP, InAs, GaAs, AlAs, InSb, GaSb, ZnS, CdS, ZnTe, CdTe, CdSe, CdS, ZnO, GaO, InO, SnO, CdO, CaO, AlO, TiO, TaO, NbO, LnO, HfO, ZrO, YO, NiO, CuO, and a combination thereof, or compounds thereof. When the insertion layer A1 is an oxide layer, the insertion layer A1 may or may not include an oxide of the same group as the channel layer C1. When the insertion layer A1 includes an oxide of the same group as the channel layer C1, the insertion layer A1 and the channel layer C1 may have different oxygen concentrations and/or doping states. An energy bandgap of the insertion layer A1 may be in the range of about 0.5 to about 4.0 eV. The insertion layer A1 may have a thickness of from about 1 to about 300Å.

When the channel layer C1 is an n-type oxide semiconductor layer, a work function of the insertion layer A1 may be greater than that of the channel layer C1. If this condition is satisfied, the insertion layer A1 may be either an n-type oxide semiconductor layer or a p-type oxide semiconductor layer. An n-type carrier concentration of the insertion layer A1 may be lower than that of the channel layer C1. Accordingly, the insertion layer A1 may be an n-type semiconductor layer having an n-type carrier concentration lower than that of the channel layer C1 or may be a p-type semiconductor layer. If both the insertion layer A1 and the channel layer C1 are n-type oxide layers, an oxygen concentration of the insertion layer A1 may be higher than that of the channel layer C1, due to the fact that, in an n-type oxide layer, as an oxygen concentration increases, a carrier concentration decreases.

When the channel layer C1 is a p-type oxide layer, a work function of the insertion layer A1 may be smaller than that of the channel layer C1. In example embodiments, the insertion layer A1 may use both the n-type oxide layer and the p-type oxide layer. The p-type carrier concentration of the insertion layer A1 may be lower than that of the channel layer C1. Accordingly, the insertion layer A1 may be a p-type semiconductor layer having a p-type carrier concentration lower than that of the channel layer C1 or may be an n-type semiconductor layer. If both the insertion layer A1 and the channel layer C1 are p-type oxide layers, an oxygen concentration of the insertion layer A1 may be lower than that of the channel layer C1, due to the fact that, in the p-type oxide layer, as the oxygen concentration decreases, the carrier concentration decreases.

As such, a material of the insertion layer A1 may be appropriately selected according to the type of the channel layer C1. As described above, the material of the insertion layer A1 may be selected from among an non-oxide semiconductor, including at least one selected from the group consisting of a Group IV-IV compound, a Group III-V compound, a Group II-VI compound, and a Group I-VII compound, and an oxide semiconductor including ZnO, GaO, InO, SnO, CdO, CaO, AlO, TiO, TaO, NbO, LnO, HfO, ZrO, YO, NiO and/or CuO.

In addition, a metal oxide, e.g., TiO, may have characteristics that vary according to its composition. For example, the metal oxide, e.g., TiO, may have a semiconductor characteristic or a conductor characteristic according to the composition. In example embodiments, an oxide semiconductor having a semiconductor characteristic may be used as the insertion layer A1. In example embodiments, the insertion layer A1 increases a potential barrier between the channel layer C1 and the source electrode S1 and does not form an ohmic-contact with the source electrode S1.

The source electrode S1 and the channel layer C1 contact each other through the insertion layer A1 interposed therebetween, and the drain electrode D1 and the channel layer C1 directly contact each other. Thus, a potential barrier between the source electrode S1 and the channel layer C1 may be different from a potential barrier between the drain electrode D1 and the channel layer C1. The potential barrier between the source electrode S1 and the channel layer C1 may be relatively higher than that of between the drain electrode D1 and the channel layer C1. As such, a structure in which the insertion layer A1 is selectively formed only between the source electrode S1 and the channel layer C1 may be defined as an asymmetric source/drain structure. Because a threshold voltage of the transistor is affected by the potential barrier between the channel layer C1 and the source electrode S1 from which electrons or holes are supplied, the insertion layer A1 may be selectively formed only in the source electrode S1 so as to control the threshold voltage. The threshold voltage may be controlled according to a height and a thickness of the potential barrier due to the insertion layer A1.

In FIG. 1, an insulating layer IL1 may be formed on the gate insulating layer GI1 so as to cover the gate electrode G1. First and second holes H1 and H2 may be formed in the insulating layer IL1 and the gate insulating layer GI1 so as to expose the channel layer C1. The first hole H1 and the second hole H2 may respectively expose both ends of the channel layer C1. Both the insertion layer A1 and the source electrode S1 may be formed inside the first hole H1, and the drain electrode D1 may be formed inside the second hole H2. Such a structure is just an example, and thus, the structure may be modified in various forms. For example, FIG. 1 shows that the insertion layer A1 may be formed only in a bottom surface of the first hole H1, but the insertion layer A1 may be coated on an inner wall surface of the first hole H1 as well.

In example embodiments, the insertion layer A1 may be formed at an end of the channel layer C1, the insulating layer IL1 may be formed so as to cover the insertion layer A1, a hole may be formed in the insulating layer IL1 so as to expose the insertion layer A1, and finally, the source electrode S1 may be formed inside the hole. In example embodiments, the insertion layer A1 may be wider than the source electrode S1. Also, in FIG. 1, the insertion layer A1 may be formed as an additional layer on the channel layer C1. However, in example embodiments, an upper portion of the channel layer C1 may be formed to have the same function as the insertion layer A1. Also, the structure of FIG. 1 may be modified to have various other forms.

As in example embodiments as illustrated in FIG. 1, if the insertion layer A1 is formed between the source electrode S1 and the channel layer C1, a potential barrier therebetween is increased due to the insertion layer A1, and a threshold voltage of the transistor may be increased. In an n-type transistor, a threshold voltage increases in a positive (+) direction. On the other hand, in a p-type transistor, a threshold voltage increases in a negative (-) direction. In the n-type transistor, when the threshold voltage is greater than 0 V, the transistor may be an enhancement mode transistor. On the other hand, in the p-type transistor, when the threshold voltage is less than 0 V, the transistor may be an enhancement mode transistor. Thus, according to example embodiments, an enhancement mode oxide transistor may be realized.

In a transistor including a channel layer formed of oxide, controlling a threshold voltage through doping due to a self-compensation phenomenon may be difficult. Also, because the oxide transistor is a majority carrier device that is operated in an accumulation mode and easily turned-on at a lower voltage, realizing an enhancement mode transistor may be difficult. However, in example embodiments, as described above, the insertion layer A1 for increasing a potential barrier is formed between the source electrode S1 and the channel layer C1, so that a threshold voltage of the oxide transistor may be increased, thereby realizing an enhancement mode transistor. Also, the threshold voltage of the oxide transistor may be appropriately controlled according to its purpose by controlling a material and a thickness of the insertion layer A1.

FIG. 2 illustrates a transistor according to example embodiments. The transistor of example embodiments may be a TFT having a bottom gate structure in which a gate electrode G2 is formed below a channel layer C2. Referring to FIG. 2, the gate electrode G2 may be formed on a substrate SUB2. An insulating layer (not shown) may be formed on the substrate SUB2, and the gate electrode G2 may be formed on the insulating layer. A gate insulating layer GI2 may be formed on the substrate SUB2 so as to cover the gate electrode G2. A channel layer C2 may be formed on the gate insulating layer GI2. The channel layer C2 may be formed above the gate electrode G2 and may be slightly wider than the gate electrode G2.

A source electrode S2 is and a drain electrode D2 may be formed on the channel layer C2 so as to respectively contact opposing sides of the channel layer C2. A semiconductor insertion layer A2 (hereinafter, an insertion layer A2) is selectively formed between the channel layer C2 and the source electrode S2. An insulating layer IL2 may be formed on the gate insulating layer GI2 so as to cover the channel layer C2. First and second holes H1' and H2' may be formed in the nsulating layer IL2. Both the insertion layer A2 and the source electrode S2 may be formed inside the first hole H1', and the drain electrode D2 may be formed inside the second hole H2'. In FIG. 2, materials, configurations, and thicknesses of the substrate SUB2, the gate electrode G2, the channel layer C2, the source electrode S2, the drain electrode D2, and the insertion layer A2 may be the same as or similar to those of the substrate SUB1, the gate electrode G1, the channel layer C1, the source electrode S1, the drain electrode D1, and the insertion layer A1 of FIG. 1.

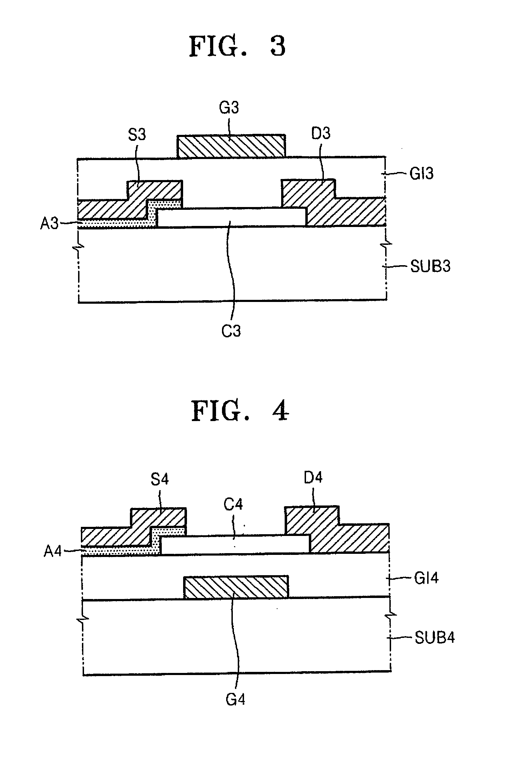

In FIGS. 1 and 2, the holes H1, H1', H2, and H2' are formed in the insulating layers IL1 and IL2, and the source electrodes S1 and S2 and the drain electrodes D1 and D2 are formed in the holes H1, H1', H2, and H2'. However, in example embodiments, a source electrode and a drain electrode may be formed without the holes H1, H1', H2, and H2', which is illustrated in FIGS. 3 and 4.

Referring to FIG. 3, a channel layer C3 may be formed on a substrate SUB3. A source electrode S3 is and a drain electrode D3 may be formed on the channel layer C3 so as to respectively cover opposing sides of the channel layer C3. An insertion layer A3 is interposed between the channel layer C3 and the source electrode S3. A gate insulating layer GI3 may be formed above the substrate SUB3 so as to cover the source electrode S3, the drain electrode D3, and the channel layer C3. A gate electrode G3 may be formed on the gate insulating layer GI3. In FIG. 3, materials, configurations, and thicknesses of the substrate SUB3, the gate electrode G3, the channel layer C3, the source electrode S3, the drain electrode D3, and the insertion layer A3 may be the same as or similar to those of the substrate SUB1, the gate electrode G1, the channel layer C1, the source electrode S1, the drain electrode D1, and the insertion layer A1 of FIG. 1.

Referring to FIG. 4, a gate electrode G4 may be formed on a substrate SUB4. A gate insulating layer GI4 may be formed on the substrate SUB4 so as to cover the gate electrode G4. The channel layer C4 may be formed on the gate insulating layer GI4, and a source electrode S4 is and a drain electrode D4 may be formed on the channel layer C4 so as to respectively cover both ends of the channel layer C4. An insertion layer A4 is interposed between the channel layer C4 and the source electrode S4. In FIG. 4, materials, configurations, and thicknesses of the substrate SUB4, the gate electrode G4, the channel layer C4, the source electrode S4, the drain electrode D4, and the insertion layer A4 may be the same as or similar to those of the substrate SUB1, the gate electrode G1, the channel layer C1, the source electrode S1, the drain electrode D1, and the insertion layer A1 of FIG. 1.

In FIGS. 3 and 4, the source and drain electrodes S3 and D3 and the source and drain electrodes S4 and D4 are respectively formed so as to contact both ends of an upper surface of the channel layers C3 and C4 through the invention layer. However, in example embodiments, a source electrode and a drain electrode may contact both ends of a lower surface of a channel layer.

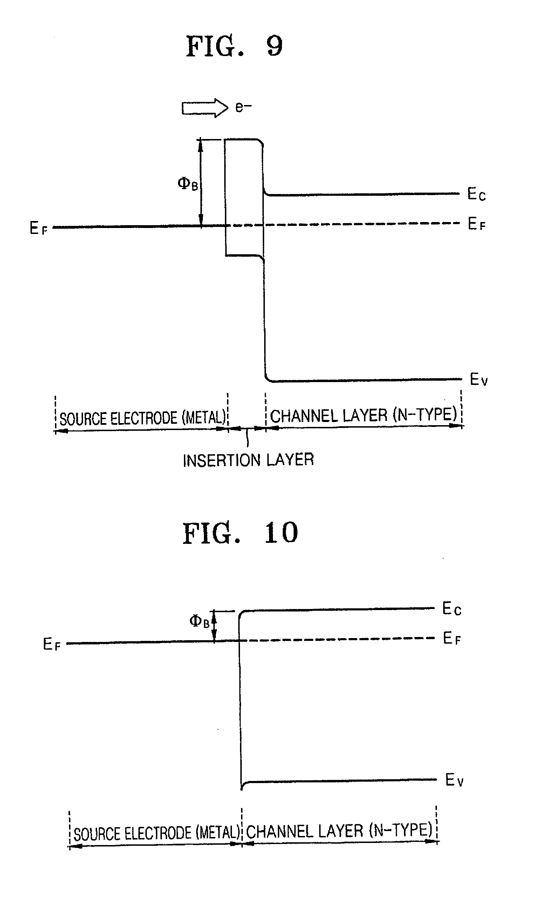

FIG. 9 is an energy band diagram illustrating a source electrode, an insertion layer, and a channel layer of a transistor, according to example embodiments. FIG. 9 illustrates an n-type channel layer. In FIG. 9, reference marks E_{C} and E_{V} denote the lowest energy level of a conduction band and the highest energy level of a valence band, respectively, and a reference mark E_{F} denotes a Fermi energy level, and these reference marks are the same as those in FIGS. 10 through 12.

Referring to FIG. 9, E_{C} of an insertion layer may be higher than that of the channel layer. This is due to the fact that when the insertion layer, having a work function greater than that of the channel layer, and the channel layer are bonded to each other, the E_{C} and E_{V} of the channel layer move downwards. Accordingly, a potential barrier Φ_{B} with respect to electrons e- may be generated between a source electrode (metal) and the channel layer due to the insertion layer. The potential barrier Φ_{B} may prevent or reduce flow of the electrons e- moving from the source electrode to the channel layer. A larger gate voltage may be required in order to move the electrons e- toward the channel layer over the potential barrier Φ_{B}. Accordingly, a threshold voltage of the transistor may increase in a positive + direction due to the insertion layer. The amount of increase of the threshold voltage may vary according to a height of the potential barrier Φ_{B} and a thickness of the insertion layer. If the insertion layer is sufficiently thin, the electrons e- may be tunneled through the insertion layer, and thus, the increase effect of the threshold voltage may be slightly decreased. However, when a user desires to minutely control the threshold voltage, the thickness of the insertion layer may be formed relatively thin. In FIG. 9, the E_{F} and E_{C} of the channel layer are close to each other, but the E_{F} and E_{C} of the insertion layer are relatively far away from each other. Therefore, an n-type carrier concentration of the insertion layer may be lower than that of the channel layer.

FIG. 10 is an energy band diagram illustrating a source electrode and a channel layer of a transistor, according to a comparative example not including an insertion layer. In example embodiments, the channel layer may be an n-type channel layer. That is, FIG. 10 illustrates the energy band diagram of a case where a source electrode and a channel layer directly contact each other without the insertion layer of FIG. 9.

Referring to FIG. 10, when the source electrode and the channel layer directly contact each other, a potential barrier Φ_{B} therebetween may be lower than that of FIG. 9. In example embodiments, the transistor may be a depletion mode transistor of which a threshold voltage is smaller than 0.

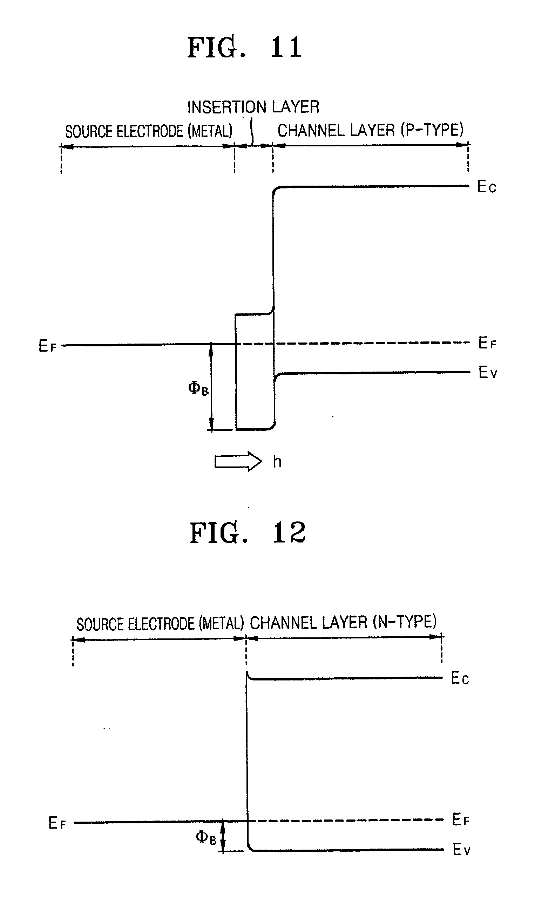

FIG. 11 is an energy band diagram illustrating a source electrode, an insertion layer, and a channel layer of a transistor, according to example embodiments. The channel layer of FIG. 11 may be a p-type channel layer. Referring to FIG. 11, E_{V} of the insertion layer may be lower than that of the channel layer. When the insertion layer, having a work function smaller than that of the channel layer, and the channel layer are bonded to each other, E_{C} and E_{V} of the channel layer move upwards. Accordingly, a potential barrier Φ_{B} with respect to holes h may be generated between the source electrode (metal) and the channel layer due to the insertion layer. The potential barrier Φ_{B} may prevent or reduce flow of the holes h moving from the source electrode to the channel layer. A larger gate voltage may be required in order to move the holes h toward the channel layer over the potential barrier Φ_{B}.

Accordingly, a threshold voltage of the transistor may increase in a negative - direction due to the insertion layer. The increase extent of the threshold voltage may vary according to a height of the potential barrier Φ_{B} and a thickness of the insertion layer. In FIG. 11, E_{F} and E_{C} of the channel layer are close to each other, but E_{F} and E_{C} of the insertion layer are relatively far away from each other. A p-type carrier concentration of the insertion layer may be lower than that of the channel layer.

FIG. 12 is an energy band diagram illustrating a source electrode and a channel layer of a transistor, according to another comparative example not including an insertion layer. In example embodiments, the channel layer may be a p-type channel layer. That is, FIG. 12 illustrates the energy band diagram of a case where a source electrode and a channel layer directly contact each other without the insertion layer of FIG. 11.

Referring to FIG. 12, when the source electrode and the channel layer directly contact each other, a potential barrier Φ_{B} therebetween may be lower than that of FIG. 11. In example embodiments, the transistor may be more easily turned-on.

As in FIGS. 9 and 11, when the insertion layer is used, a potential barrier between the source electrode and the channel layer is increased, and thus, a threshold voltage of the transistor may be increased. Accordingly, the transistor may be an enhancement mode transistor. However, the transistor of example embodiments may not be necessarily an enhancement mode transistor. The threshold voltage of the transistor may be controlled while maintaining the transistor in a depletion mode, according to its purpose.

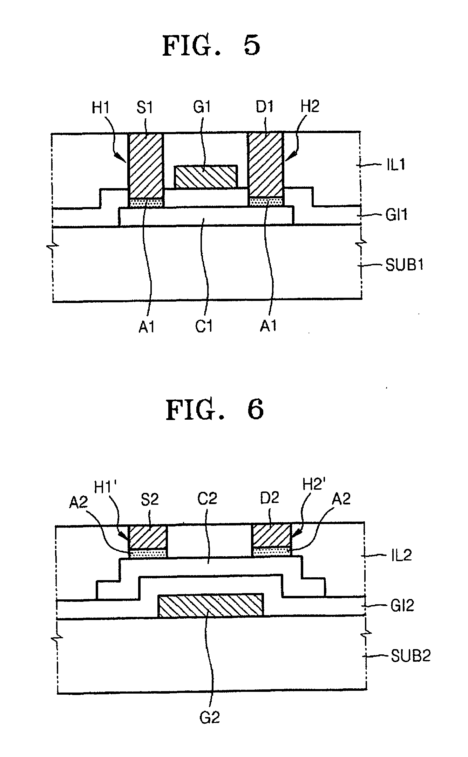

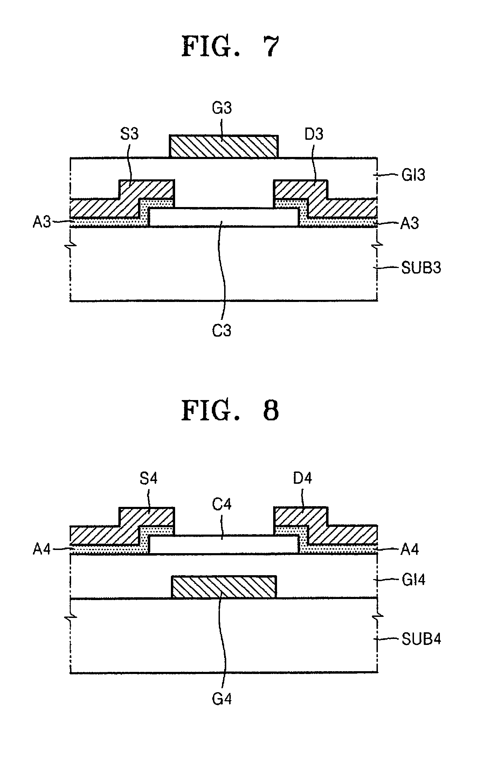

FIGS. 1 through 4 illustrate the asymmetrical source/drain structure in which the semiconductor insertion layers A1 through A4 are respectively formed only in the source electrode S1 through S4. However, according to example embodiments, the semiconductor insertion layers A1 through A4 may be respectively formed in the drain electrodes D1 through D4, and those examples are illustrated in FIGS. 5 through 8.

The structures of FIGS. 5 through 8 are modified examples of structures illustrated in FIGS.1 through 4. The structures of FIGS. 5 through 8 further include the insertion layers A1 through A4 between the channel layers C1 through C4 and the drain electrodes D1 through D4. The rest of the components are the same as those of FIGS. 1 through 4. As such, a structure in which the insertion layers A1 through A4 are respectively formed in both the source electrodes S1 through S4 and the drain electrodes D1 through D4 is referred to as a symmetric source/drain structure.

As in FIGS. 5 through 8, when the insertion layers A1 through A4 are formed both between the source electrodes S1 through S4 and the channel layers C1 through C4 and between the drain electrodes D1 through D4 and the channel layers C1 through C4, the manufacturing process may be simplified compared to the asymmetrical source/drain structure of FIGS. 1 through 4. In example embodiments, a threshold voltage of a transistor may be controlled by the insertion layers A1 through A4 formed between the source electrodes S1 through S4 and the channel layers C1 through C4, because the threshold voltage of the transistor may be influenced by the potential barriers of the source electrodes S1 through S4 from which charges (electrons or holes) are supplied, compared to the potential barriers of the drain electrodes D1 through D4.

The transistor having the asymmetrical source/drain structure of FIGS. 1 through 4, that is, the transistor in which the insertion layers A1 through A4 are selectively formed only between the source electrodes S1 through S4 and the channel layers C1 through C4 may be more advantageous in terms of mobility, compared to the transistor having the symmetrical source/drain structure of FIGS. 5 through 8. In the transistor having the asymmetrical source/drain structure, the potential barriers of the drain electrodes D1 through D4 may be lower, and thus, charges may be more easily discharged to the drain electrodes D1 through D4.

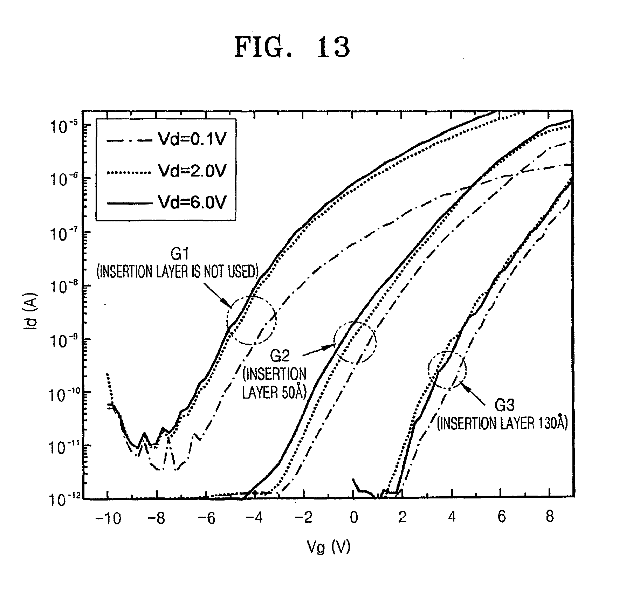

FIG. 13 is a graph illustrating gate voltage V_{g}-drain current I_{d} characteristics of transistors according to example embodiments and a comparative example. The transistor according to example embodiments may have the same structure as the transistor of FIG. 5, and uses a GalnZnO layer and an IZO layer as the channel layer C1 and the insertion layer A1, respectively. Both the channel layer (the GalnZnO layer) and the insertion layer (the IZO layer) may be n-type oxide semiconductor layers. An n-type carrier concentration of the insertion layer (the IZO layer) may be lower than that of the channel layer (the GalnZnO layer). Characteristics of cases where thicknesses of the insertion layer (the IZO layer) may be respectively 50Å and 130Å were evaluated.

A characteristic of the transistor that does not use an insertion layer (that is, the transistor according to the comparative example) was evaluated. The transistor according to the comparative example has a structure that is the same as that of the transistor according to example embodiments, except that the transistor according to the comparative example does not use an insertion layer. In the graph of FIG. 13, plots of a first group G1 show a result regarding the transistor according to the comparative example, and plots of second and third groups G2 and G3 show results regarding the transistor according to example embodiments. The plots of the second group G2 show a case where a thickness of the insertion layer (the IZO layer) may be 50Å, and the plots of the third group G3 shows a case where a thickness of the insertion layer (the IZO layer) may be 130Å.

Referring to FIG. 13, the plots of the first group G1 showing a result regarding the transistor according to the comparative example may be turned-on at a considerably low voltage. On the other hand, the plots of the second and third groups G2 and G3 showing results regarding the transistor according to example embodiments may be located at a right side compared to the plots of the first group G1, which shows that, when an insertion layer is used, a threshold voltage increases in a positive + direction. The plots of the third group G3 may be located at a right side compared to the plots of the second group G2, which shows that as a thickness of the insertion layer increases, the threshold voltage may increase more.

In addition, a threshold voltage may be increased by using another method of forming a source electrode with a material (metal) forming a Schottky junction with a channel layer. However, to form a Schottky junction with an n-type oxide channel layer, a metal having a relatively high work function (more than about 4.5 to about 4.7 eV) may be used. Accordingly, metals used in the source electrode may be limited. Furthermore, metals having relatively high work functions may be mostly expensive precious metals, and may also be hard to etch. When a Schottky junction is used, ensuring uniformity of characteristics between transistors may be difficult, and also, a relatively large amount of leakage current may be generated. However, as in example embodiments, when a threshold voltage is increased by using a semiconductor insertion layer, the choice of a source/drain electrode material may be wider, and also various problems, e.g., an etching issue, non-uniformity of characteristics, or leakage current, may be prevented or reduced.

While example embodiments have been shown and described with reference to the accompanying drawings, the scope of the present application should not be construed as being limited to example embodiments. For instance, one of ordinary skill in the art would understand that the teachings herein may be applied to other transistors besides TFTs. Also, the constituent elements and structures of the transistors of FIGS. 1 through 8 may be modified in various forms. In more detail, the transistor according to example embodiments may have a double gate structure. Therefore, the scope of the present application should not be interpreted as being unduly limited to the literal text of the detailed description.

## Claims

1. A transistor comprising:
a channel layer (C1, C2, C3, C4) including an oxide semiconductor;
a gate electrode (G1, G2, G3, G4) corresponding to the channel layer;
a source electrode (S1, S2, S3, S4) and a drain electrode (D1, D2, D3, D4); and
a semiconductor insertion layer (A1, A2, A3, A4) between the channel layer (C1, C2, C3, C4) and the source electrode (S1, S2, S3, S4), the semiconductor insertion layer (A1, A2, A3, A4) being a layer comprising a semiconductor,
the source electrode and the channel layer contacting each other through the semiconductor insertion layer
**characterised in that** the semiconductor insertion layer (A1, A2, A3, A4) is arranged on the channel layer (C1, C2, C3, C4) to provide a potential barrier between the channel layer and the source electrode greater than the potential barrier between the channel layer and the source electrode without the semiconductor insertion layer, and the channel layer (C1,C2,C3,C4) is not in direct contact with the source electrode (S1,S2,S3,S4) by the semiconductor insertion layer.

2. The transistor of claim 1, wherein the semiconductor insertion layer is provided between the channel layer and the source electrode, but not between the channel layer and the drain electrode, the semiconductor insertion layer being a layer comprising semiconductor arranged to provide a potential barrier between the channel layer and the source electrode greater than the potential barrier between the channel layer and the drain electrode.

3. The transistor of claim 1 or 2, wherein the channel layer (C1, C2, C3, C4) is an n-type channel layer, and a work function of the semiconductor insertion layer (A1, A2, A3, A4) is greater than that of the channel layer.

4. The transistor of claim 3, wherein an n-type carrier concentration of the semiconductor insertion layer (A1, A2, A3, A4) is lower than that of the channel layer (C1, C2, C3, C4).

5. The transistor of claim 1 or 2, wherein the channel layer is a p-type channel layer, and a work function of the semiconductor insertion layer (A1, A2, A3, A4) is smaller than that of the_channel layer (C1, C2, C3, C4)

6. The transistor of claim 5, wherein a p-type carrier concentration of the semiconductor insertion layer (A1, A2, A3, A4) is lower than that of the channel layer (C1, C2, C3, C4).

7. The transistor of any preceding claim, wherein the channel layer (C1, C2, C3, C4) includes any one selected from the group consisting of ZnO, GaO, InO, SnO, CdO, CaO, AIO, TiO, TaO, NbO, LnO, HfO, ZrO, YO, NiO, CuO, and a combination thereof, or oxide sem iconductors thereof.

8. The transistor of claim 7, wherein the channel layer (C1, C2, C3, C4) is formed of a ZnO-based oxide semiconductor, and optionally wherein the ZnO-based oxide semiconductor further includes at least one selected from the group consisting of In, Ga, Sn, Ti, Zr, Hf, Y, and Ta.

9. The transistor of any preceding claim, wherein the semiconductor insertion layer (A1, A2, A3, A4) includes one selected from the group consisting of SiC, AIN, GaN, InN, AIP, GaP, InAs, GaAs, AlAs, InSb, GaSb, ZnS, CdS, ZnTe, CdTe, CdSe, CdS, ZnO, GaO, InO, SnO, CdO, CaO, AIO, TiO, TaO, NbO, LnO, HfO, ZrO, YO, NiO, CuO, and a combination thereof, or compounds thereof.

10. The transistor of any preceding claim, wherein the semiconductor insertion layer (A1, A2, A3, A4) has an energy bandgap of about 0.5 to about 4.0 eV

11. The transistor of any preceding claim, wherein the semiconductor insertion layer (A1, A2, A3, A4) has a thickness of about 1 to about 300Å.

12. The transistor of any preceding claim, wherein the transistor is an enhancement mode transistor.

13. The transistor of claim 1, wherein the semiconductor insertion layer (A1, A2, A3, A4) is a first semiconductor insertion layer, further comprising:
a second semiconductor insertion layer (A1, A2, A3, A4) between the channel layer (C1, C2, C3, C4) and the drain electrode (D1, D2, D3, D4), and optionally wherein the first and second semiconductor insertion layers (A1, A2, A3, A4) are formed of the same material.

14. The transistor of any preceding claim, wherein the transistor is a thin film transistor (TFT) having a top-gate structure or a TFT having a bottom-gate structure.

15. The transistor of any preceding claim, further comprising:
a gate insulating layer (G11, G12, G13, G14) between the channel layer (C1, C2, C3, C4) and the gate electrode (G1, G2, G3, G4);
wherein the gate insulating layer (G11, G12, G13, G14) includes one selected from the group consisting of a silicon oxide layer, a silicon nitride layer, and a high-dielectric material layer having a dielectric constant greater than that of the silicon nitride layer; or
wherein the gate insulating layer (GI1, GI2, GI3, GI4) has a structure including at least two stacked layers from among the silicon oxide layer, the silicon nitride layer, and the high-dielectric material layer.

## Patentansprüche

1. Transistor, der Folgendes umfasst:
eine Kanalschicht (C1, C2, C3, C4), umfassend einen Oxidhalbleiter;
eine zu der Kanalschicht entsprechende Gate-Elektrode (G1, G2, G3, G4);
eine Source-Elektrode (S1, S2, S3, S4) und eine Drain-Elektrode (D1, D2, D3, D4); und
eine Halbleiter-Einschubschicht (A1, A2, A3, A4) zwischen der Kanalschicht (C1, C2, C3, C4) und der Source-Elektrode (S1, S2, S3, S4), wobei es sich bei der Halbleiter-Einschubschicht (A1, A2, A3, A4) um eine einen Halbleiter umfassenden Schicht handelt;
wobei die Source-Elektrode und die Kanalschicht durch die Halbleiter-Einschubschicht miteinander in Kontakt stehen;
**dadurch gekennzeichnet, dass** die Halbleiter-Einschubschicht (A1, A2, A3, A4) auf der Kanalschicht (C1, C2, C3, C4) angeordnet ist, um eine Potentialsperre zwischen der Kanalschicht und der Source-Elektrode vorzusehen, die größer ist als die Potentialsperre zwischen der Kanalschicht und der Source-Elektrode ohne die Halbleiter-Einschubschicht und die Kanalschicht (C1, C2, C3, C4) durch die Halbleiter-Einschubschicht nicht in direktem Kontakt mit der Source-Elektrode (S1, S2, S3, S4) steht.

2. Transistor nach Anspruch 1, wobei die Halbleiter-Einschubschicht zwischen der Kanalschicht und der Source-Elektrode aber nicht zwischen der Kanalschicht und der Drain-Elektrode vorgesehen ist, wobei es sich bei der Halbleiter-Einschubschicht um eine Schicht handelt, die einen Halbleiter umfasst, der dazu angeordnet ist, eine Potentialsperre zwischen der Kanalschicht und der Source-Elektrode vorzusehen, die größer ist als die Potentialsperre zwischen der Kanalschicht und der Drain-Elektrode.

3. Transistor nach Anspruch 1 oder 2, wobei es sich bei der Kanalschicht (C1, C2, C3, C4) um eine n-Kanalschicht handelt und eine Austrittsarbeit der Halbleiter-Einschubschicht (A1, A2, A3, A4) größer ist als die der Kanalschicht.

4. Transistor nach Anspruch 3, wobei eine n-Trägerkonzentration der Halbleiter-Einschubschicht (A1, A2, A3, A4) geringer ist als die der Kanalschicht (C1, C2, C3, C4).

5. Transistor nach Anspruch 1 oder 2, wobei es sich bei der Kanalschicht um eine p-Kanalschicht handelt und eine Austrittsarbeit der Halbleiter-Einschubschicht (A1, A2, A3, A4) kleiner ist als die der Kanalschicht (C1, C2, C3, C4).

6. Transistor nach Anspruch 5, wobei eine p-Trägerkonzentration der Halbleiter-Einschubschicht (A1, A2, A3, A4) geringer ist als die der Kanalschicht (C1, C2, C3, C4).

7. Transistor nach einem der vorangehenden Ansprüche, wobei es sich bei der Kanalschicht (C1, C2, C3, C4) um ein beliebiges aus der aus ZnO, GaO, InO, SnO, CdO, CaO, AlO, TiO, TaO, NbO, LnO, HfO, ZrO, YO, NiO, CuO und einer Kombination derselben oder Oxidhalbleitern derselben bestehenden Gruppe Ausgewähltes handelt.

8. Transistor nach Anspruch 7, wobei die Kanalschicht (C1, C2, C3, C4) aus einem Oxidhalbleiter auf ZnO-Basis gebildet ist und wobei optional der Oxidhalbleiter auf ZnO-Basis weiter mindestens ein aus der aus In, Ga, Sn, Ti, Zr, Hf, Y und Ta bestehenden Gruppe Ausgewähltes umfasst.

9. Transistor nach einem der vorangehenden Ansprüche, wobei die Halbleiter-Einschubschicht (A1, A2, A3, A4) ein aus der aus SiC, AIN, GaN, InN, AlP, GaP, InAs, GaAs, AIAs, InSb, GaSb, ZnS, CdS, ZnTe, CdTe, CdSe, CdS, ZnO, GaO, InO, SnO, CdO, CaO, AlO, TiO, TaO, NbO, LnO, HfO, ZrO, YO, NiO, CuO und einer Kombination derselben oder Verbindungen derselben bestehenden Gruppe Ausgewähltes umfasst.

10. Transistor nach einem der vorangehenden Ansprüche, wobei die Halbleiter-Einschubschicht (A1, A2, A3, A4) eine Energiebandlücke von ungefähr 0,5 bis ungefähr 4,0 eV aufweist.

11. Transistor nach einem der vorangehenden Ansprüche, wobei die Halbleiter-Einschubschicht (A1, A2, A3, A4) eine Dicke von ungefähr 1 bis ungefähr 300 Å aufweist.

12. Transistor nach einem der vorangehenden Ansprüche, wobei es sich bei dem Transistor um einen Anreicherungstransistor handelt.

13. Transistor nach Anspruch 1, wobei es sich bei der Halbleiter-Einschubschicht (A1, A2, A3, A4) um eine erste Halbleiter-Einschubschicht handelt, weiter umfassend:
eine zweite Halbleiter-Einschubschicht (A1, A2, A3, A4) zwischen der Kanalschicht (C1, C2, C3, C4) und der Drain-Elektrode (D1, D2, D3, D4) und wobei optional die erste und die zweite Halbleiter-Einschubschicht (A1, A2, A3, A4) aus dem selben Material gebildet sind.

14. Transistor nach einem der vorangehenden Ansprüche, wobei es sich bei dem Transistor um einen Dünnfilmtransistor (TFT) mit einer Top-Gate-Struktur oder um einen TFT mit einer Bottom-Gate-Struktur handelt.

15. Transistor nach einem der vorangehenden Ansprüche, der weiter Folgendes umfasst:
eine Gate-Isolierschicht (GI1, GI2, GI3, GI4) zwischen der Kanalschicht (C1, C2, C3, C4) und der Gate-Isolierschicht (G1, G2, G3, G4);
wobei die Gate-Elektrode (GI1, GI2, GI3, GI4) eine aus der aus einer Siliziumoxidschicht,
einer Siliziumnitridschicht und einer Materialschicht hoher Dielektrizität mit einer Dielektrizitätskonstante, die größer ist als die der Siliziumnitridschicht bestehenden Gruppe Ausgewählte umfasst; oder
wobei die Gate-Isolierschicht (GI1, GI2, GI3, GI4) eine Struktur mit mindestens zwei gestapelten Schichten, ausgewählt aus der Siliziumoxidschicht, der Siliziumnitridschicht und der Materialschicht hoher Dielektrizität aufweist.

## Revendications

1. Transistor comprenant :
une couche de canal (C1, C2, C3, C4) comportant un semi-conducteur d'oxyde ;
une électrode de grille (G1, G2, G3, G4) correspondant à la couche de canal ;
une électrode de source (S1, S2, S3, S4) et une électrode de drain (D1, D2, D3, D4) ; et
une couche d'insertion à semi-conducteur (A1, A2, A3, A4) entre la couche de canal (C1, C2, C3, C4) et l'électrode de source (S1, S2, S3, S4), la couche d'insertion à semi-conducteur (A1, A2, A3, A4) étant une couche comprenant un semi-conducteur ;
l'électrode de source et la couche de canal se contactant l'une l'autre par le biais de la couche d'insertion à semi-conducteur ;
**caractérisé en ce que** la couche d'insertion à semi-conducteur (A1, A2, A3, A4) est agencée sur la couche de canal (C1, C2, C3, C4) afin de produire entre la couche de canal et l'électrode de source une barrière de potentiel supérieure à la barrière de potentiel entre la couche de canal et l'électrode de source sans la couche d'insertion à semi-conducteur, et la couche de canal (C1, C2, C3, C4) n'est pas en contact direct avec l'électrode de source (S1, S2, S3, S4) par le biais de la couche d'insertion à semi-conducteur.

2. Transistor selon la revendication 1, dans lequel la couche d'insertion à semi-conducteur est fournie entre la couche de canal et l'électrode de source, mais pas entre la couche de canal et l'électrode de drain, la couche d'insertion à semi-conducteur étant une couche comprenant un semi-conducteur agencé pour produire entre la couche de canal et l'électrode de source une barrière de potentiel supérieure à la barrière de potentiel entre la couche de canal et l'électrode de drain.

3. Transistor selon la revendication 1 ou 2, dans lequel la couche de canal (C1, C2, C3, C4) est une couche de canal de type N, et une fonction de travail de la couche d'insertion à semi-conducteur (A1, A2, A3, A4) est supérieure à celle de la couche de canal.

4. Transistor selon la revendication 3, dans lequel une concentration de porteurs de type N de la couche d'insertion à semi-conducteur (A1, A2, A3, A4) est inférieure à celle de la couche de canal (C1, C2, C3, C4).

5. Transistor selon la revendication 1 ou 2, dans lequel la couche de canal est une couche de canal de type P, et une fonction de travail de la couche d'insertion à semi-conducteur (A1, A2, A3, A4) est inférieure à celle de la couche de canal (C1, C2, C3, C4).

6. Transistor selon la revendication 5, dans lequel une concentration de porteurs de type P de la couche d'insertion à semi-conducteur (A1, A2, A3, A4) est inférieure à celle de la couche de canal (C1, C2, C3, C4).

7. Transistor selon l'une quelconque des revendications précédentes, dans lequel la couche de canal (C1, C2, C3, C4) comporte un élément quelconque sélectionné dans le groupe consistant en ZnO, GaO, InO, SnO, CdO, CaO, AlO, TiO, TaO, NbO, LnO, HfO, ZrO, YO, NiO, CuO, et une combinaison de ceux-ci, ou des semi-conducteurs d'oxyde de ceux-ci.

8. Transistor selon la revendication 7, dans lequel la couche de canal (C1, C2, C3, C4) est formée d'un semi-conducteur d'oxyde à base de ZnO, et facultativement dans lequel le semi-conducteur d'oxyde à base de ZnO comporte en outre au moins un élément sélectionné dans le groupe consistant en In, Ga, SnN, Ti, Zr, Hf, Y et Ta.

9. Transistor selon l'une quelconque des revendications précédentes, dans lequel la couche d'insertion à semi-conducteur (A1, A2, A3, A4) comporte un élément sélectionné dans le groupe consistant en SiC, AIN, GaN, InN, AIP, GaP, InAs, GaAs, AlAs, InSb, GaSb, ZnS, CdS, ZnTe, CdTe, CdSe, CdS, ZnO, GaO, InO, SnO, CdO, CaO, AlO, TiO, TaO, NbO, LnO, HfO, ZrO, YO, NiO, CuO, et une combinaison de ceux-ci, ou des composés de ceux-ci.

10. Transistor selon l'une quelconque des revendications précédentes, dans lequel la couche d'insertion à semi-conducteur (A1, A2, A3, A4) a une bande interdite d'énergie d'environ 0,5 à environ 4,0 eV.

11. Transistor selon l'une quelconque des revendications précédentes, dans lequel la couche d'insertion à semi-conducteur (A1, A2, A3, A4) a une épaisseur d'environ 1 à environ 300 Å.

12. Transistor selon l'une quelconque des revendications précédentes, dans lequel le transistor est un transistor à mode d'enrichissement.

13. Transistor selon la revendication 1, dans lequel la couche d'insertion à semi-conducteur (A1, A2, A3, A4) est une première couche d'insertion à semi-conducteur, comprenant en outre:
une seconde couche d'insertion à semi-conducteur (A1, A2, A3, A4) entre la couche de canal (C1, C2, C3, C4) et l'électrode de drain (D1, D2, D3, D4), et facultativement dans lequel les première et seconde couches d'insertion a semi-conducteur (A1, A2, A3, A4) sont formées dans le même matériau.

14. Transistor selon l'une quelconque des revendications précédentes, dans lequel le transistor est un transistor à couche mince (TFT) ayant une structure à grille supérieure ou un TFT ayant une structure à grille inférieure.

15. Transistor selon l'une quelconque des revendications précédentes, comprenant en outre :
une couche d'isolation de grille (GI1, GI2, GI3, GI4) entre la couche de canal (C1, C2, C3, C4) et l'électrode de grille (G1, G2, G3, G4) ;
dans lequel la couche d'isolation de grille (GI1, GI2, GI3, GI4) comporte un élément sélectionné dans le groupe consistant en une couche d'oxyde de silicium, une couche de nitrure de silicium, et une couche de matériau fortement diélectrique ayant une constante diélectrique supérieure à celle de la couche de nitrure de silicium ; ou
dans lequel la couche d'isolation de grille (GI1, GI2, GI3, GI4) a une structure comportant au moins deux couches empilées parmi la couche d'oxyde de silicium, la couche de nitrure de silicium, et la couche de matériau fortement diélectrique.
